# EUROPEAN PATENT APPLICATION

(11) **EP 4 303 244 A1**
(43) Date of publication of application: **10.01.2024**
(21) Application number: 22763264.3
(22) Date of filing: 01.03.2022
(51) Int. Cl.: C08F 299/06, H01L 41/06, H01L 41/12, H01L 41/20, H01L 41/47, C08G 18/42, C08G 18/67, C08G 18/73, C08G 18/75, H01F 1/053, H01F 1/08, H01F 1/28

(54) **COMPOSITION HAVING MAGNETOSTRICTIVE PROPERTIES, AND CURED PRODUCT THEREOF**

(30) Priority: 01.03.2021 JP 2021031516
(71) Applicant: TOKYO OHKA KOGYO CO., LTD., Kawasaki-shi, Kanagawa 211 0012 (JP); Tohoku University, Sendai-shi, Miyagi 980-8577 (JP)
(72) Inventor: SENZAKI, Takahiro, Kawasaki-shi, Kanagawa 211-0012 (JP); KURITA, Hiroki, Sendai-shi, Miyagi 980-8577 (JP); NARITA, Fumio, Sendai-shi, Miyagi 980-8577 (JP)
(74) Representative: Plasseraud IP
(86) International application number: PCT/JP2022/008636
(87) International publication number: WO 2022/186209

(57) **Abstract**

Provided is a composition having magnetostrictive properties, which contains a component (P): a compound having a polymerizable group, a component (M): a powdery magnetostrictive material, and a component (R): a radical polymerization initiator.

## Description

### [Technical Field]

The present invention relates to a composition having magnetostrictive properties, and a cured product thereof.

Priority is claimed on Japanese Patent Application No. 2021-031516, filed March 1, 2021, the content of which is incorporated herein by reference.

### [Background Art]

A magnetostrictive material is a material which is slightly deformed in a case where a magnetic field is applied, and the phenomenon of this deformation is called " magneto striction".

Conversely, in a case where force is applied to the magnetostrictive material to be deformed, an inverse magnetostriction phenomenon occurs in which a magnetic field inside the material changes. The change in magnetic field due to the inverse magnetostriction phenomenon can be used for sensors and vibration-powered generators. The magnetostriction is a property of ferromagnetic materials. Ferromagnetic materials such as Fe (iron), Co (cobalt), and Ni (nickel) can be changed in shape at a proportion of approximately 0.01% to 0.0001% with respect to an original shape. In addition, as a magnetostrictive material having high magnetostrictive properties called giant magnetostriction, Terfenol-D (Fe-Dy (dysprosium)-Tb (terbium) alloy), Galfenol (Fe-Ga (gallium) alloy), or Fe-Co alloy has been known.

As the magnetostrictive material, in the related art, a composite-reinforced magnetostrictive composite material in which a wire consisting of an iron-based magnetostrictive alloy is embedded in a base material (matrix) as a filler material (filler) has been proposed.

Specifically, it is disclosed that a Fe-Co fiber reinforced composite material is obtained by arranging Fe-Co fibers as the filler material in one direction in a mold, and then pouring an epoxy resin base material into the mold and curing the resin base material under the condition that a predetermined stress is applied (see Patent Document 1).

### [Citation List]

### [Patent Document]

[Patent Document 1]
Japanese Unexamined Patent Application, First Publication No. 2017-163119

### [Summary of Invention]

### [Technical Problem]

However, in the composite-reinforced magnetostrictive composite material disclosed in Patent Document 1, it is necessary to arrange a plurality of wires consisting of an iron-based magnetostrictive alloy in the same direction, which requires complicated operations.

By the way, as described above, the magnetostrictive material in which surrounding magnetic field changes under stress load is expected to be used as energy harvesters by repeated stress loading or as stress sensors.

However, the magnetostrictive material having high magnetostrictive properties, such as Terfenol-D and Galfenol, has a problem that it is difficult to withstand repeated stress loading due to its brittleness. The Fe-Co alloy, which has slightly inferior magnetostrictive properties, has slightly better mechanical properties, but fatigue properties are still insufficient.

The present invention is made in view of the above-described circumstances, and an object of the present invention is to provide a novel magnetostrictive composite material having magnetostrictive properties.

### [Solution to Problem]

The present inventors have newly developed a magnetostrictive composite material in which a powdery magnetostrictive material is employed and the magnetostrictive material is dispersed in a base material which is cured by a radical polymerization. That is, in order to solve the above-described problem, the present invention employs the following configurations.

[1] A composition having magnetostrictive properties, containing:
   a component (P): a compound having a polymerizable group;
   a component (M): a powdery magnetostrictive material; and
   a component (R): a radical polymerization initiator.
[2] The composition according to [1],
   in which the component (M) is a group of particles consisting of an iron-based magnetostrictive alloy and having an average particle size of 5 µm or more and 50 µm or less.
[3] The composition according to [1] or [2],
   in which a content of the component (M) is 40% by volume or more and 60% by volume or less with respect to a total volume of the component (P), the component (M), and the component (R), and
   the composition has negative magnetostrictive properties.
[4] The composition according to any one of [1] to [3],
   in which a content of the component (R) is 0.01 parts by mass or more and 20 parts by mass or less with respect to 100 parts by mass of the component (P).
[5] The composition according to any one of [1] to [4],
   in which the component (P) is a thermosetting resin having a polymerizable unsaturated double bond.
[6] The composition according to any one of [1] to [5],
   in which the component (P) is a thermosetting elastomer having a glass transition temperature of -130°C or higher and -5°C or lower.
[7] The composition according to [6],
   in which the thermosetting elastomer is a urethane (meth)acrylate.
[8] The composition according to [7],
   in which the thermosetting elastomer is a urethane (meth)acrylate having a weight-average molecular weight of 2,000 or more and 30,000 or less, which is obtained by reacting polycaprolactone polyol having a number-average molecular weight of 300 or more and 900 or less, an aliphatic or alicyclic diisocyanate, and a hydroxyl group-containing (meth)acrylate.
[9] A cured product obtained by curing the composition according to any one of [1] to [8].

### [Advantageous Effects of Invention]

According to the present invention, it is possible to provide a novel magnetostrictive composite material having magnetostrictive properties.

### [Brief Description of Drawings]

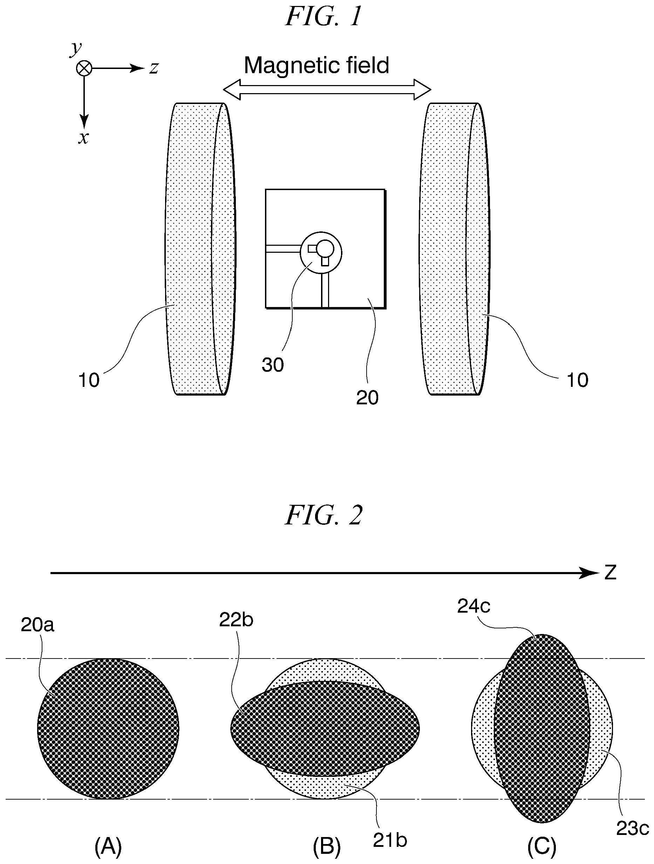

FIG. 1 is a schematic diagram representing a method for evaluating magnetostrictive properties in the present example.
FIG. 2 is a schematic plan view of component (M) particles dispersed in a cured product sample before and after application of a magnetic field. In FIG. 2, an arrow (z-axis direction) indicates an application direction of the magnetic field. FIG. 2(A) shows a state of the component (M) particles dispersed in the cured product sample before the application of the magnetic field. FIG. 2(B) shows a state (positive magnetostriction) of the component (M) particles dispersed in the cured product sample after the application of the magnetic field. FIG. 2(C) shows a state (negative magnetostriction) of the component (M) particles dispersed in the cured product sample after the application of the magnetic field.

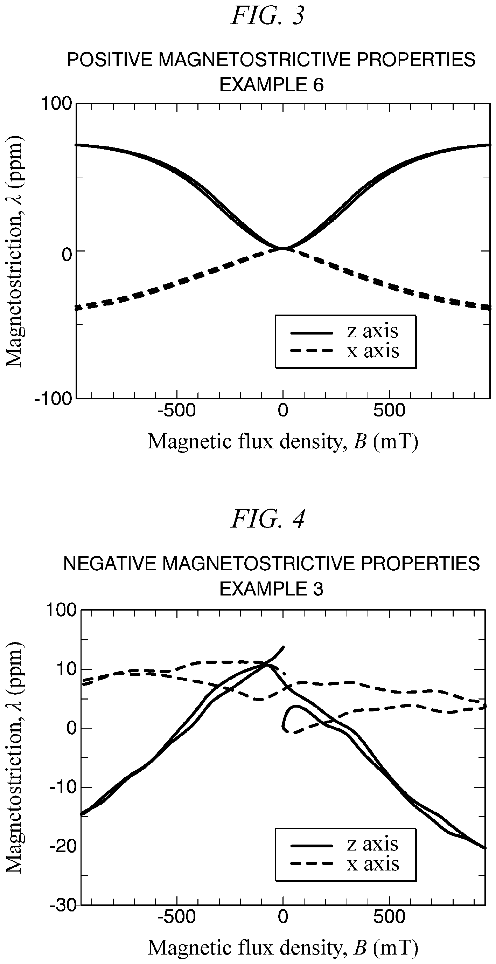

FIG. 3 is a diagram representing the change in shape of the component (M) particles dispersed in the cured product sample upon the application of the magnetic field, with regard to a cured product obtained by curing a composition of Example 6. The vertical axis indicates magnetostriction, λ (ppm). The horizontal axis indicates magnetic flux density, B (mT).
FIG. 4 is a diagram representing the change in shape of the component (M) particles dispersed in the cured product sample upon the application of the magnetic field, with regard to a cured product obtained by curing a composition of Example 3. The vertical axis indicates magnetostriction, λ (ppm). The horizontal axis indicates magnetic flux density, B (mT).

### [Description of Embodiments]

### (Composition having magnetostrictive properties)

The composition according to the present embodiment is a magnetostrictive composite material having magnetostrictive properties, which contains a component (P): a compound having a polymerizable group, a component (M): a powdery magnetostrictive material, and a component (R): a radical polymerization initiator.

The magnetostrictive properties of the magnetostrictive composite material mean at least a property of changing dimensions in a case where a magnetic field is applied or a property of changing a magnetic field inside the material in a case where a pressure is applied.

In the former property, in a case where the magnetic field is applied in one direction, a phenomenon of elongation in the same direction is called "positive magnetostriction", and a phenomenon of contraction in the same direction is called "negative magnetostriction".

The composition according to the present embodiment can exhibit not only the positive magnetostriction, but also the negative magnetostriction.

A form of the composition according to the present embodiment is not particularly limited, and as a preferred form, a form in which the powdery magnetostrictive material is dispersed in the composition is an exemplary example.

In addition, the form of the composition according to the present embodiment may be, for example, a dispersion liquid or solution, or may be powder or lump.

### <Component (P): compound having polymerizable group>

The component (P) can constitute a base material (matrix) of the cured product by being polymerized by an action of the component (R) in a case where the composition is cured.

The "polymerizable group" in the component (P) is a group in which a compound having the polymerizable group can be polymerized by a radical polymerization or the like, and for example, refers to a group having a multiple bond between carbon atoms, such as a polymerizable unsaturated double bond.

The "polymerizable group" in the component (P) is not particularly limited, but is preferably radically polymerizable.

The multiple bond between carbon atoms may be a polymerizable carbon-carbon double bond or a polymerizable carbon-carbon triple bond, and a polymerizable carbon-carbon double bond is preferable. As the polymerizable carbon-carbon double bond, for example, a methacryloyl group and an acryloyl group are exemplary examples.

The polymerizable group included in the component (P) may be one kind or two or more kinds thereof.

As the component (P), from the viewpoint of applications which take advantage of the magnetostrictive properties, it is preferable to use a thermosetting resin, and it is more preferable to use a thermosetting resin having a polymerizable unsaturated double bond.

The number of polymerizable groups included in the component (P) can be appropriately determined depending on the applications.

For example, as the component (P), a compound having 1 to 6 polymerizable groups is an exemplary example, and from the viewpoint of durability, low elastic modulus and the like against repeated stress loading, a compound having 1 to 5 polymerizable groups is preferable, a compound having 1 to 4 polymerizable groups is more preferable, and a compound having 1 or 2 polymerizable groups is particularly preferable.

In addition, from the viewpoint of durability, low elastic modulus and the like against repeated stress loading, the component (P) is preferably a thermosetting resin having a low glass transition temperature, and more preferably a thermosetting resin having a glass transition temperature of 0°C or lower.

In the present specification and claims, the "glass transition temperature" indicates a value measured by a test method in accordance with JIS K 7244-1: 1998 (ISO 6721-1: 1994).

Among the above, from the viewpoint of durability, low elastic modulus and the like against repeated stress loading, the component (P) is preferably a thermosetting elastomer. The thermosetting elastomer tends to have a low elastic modulus after curing.

As the component (P), a thermosetting elastomer having a glass transition temperature of 0°C or lower is more preferable, a thermosetting elastomer having a glass transition temperature of -130°C or higher and -5°C or lower is still more preferable, a thermosetting elastomer having a glass transition temperature of -100°C or higher and - 5°C or lower is particularly more preferable, and a thermosetting elastomer having a glass transition temperature of -50°C or higher and -10°C or lower is most preferable.

In a case where the glass transition temperature of the thermosetting elastomer as the component (P) is equal to or lower than the upper limit value of the above-described preferred range, it is easy to achieve a low elastic modulus in a case of being formed into a cured product, and in a case of being equal to or higher than the lower limit value of the above-described preferred range, strength in a case of being formed into a cured product can be enhanced.

### << Thermosetting elastomer>>

As the thermosetting elastomer, for example, a resin-based elastomer is an exemplary example, and a urethane (meth)acrylate is a suitable exemplary example.

The urethane (meth)acrylate can be synthesized by an addition reaction of a polyol (component (O)), a polyisocyanate compound (component (I)), and a hydroxyl group-containing (meth)acrylate. For example, the urethane (meth)acrylate can be synthesized by performing a known urethanization reaction.

Here, the "(meth)acrylate" is a concept including methacrylate and acrylate, and means methacrylate or acrylate.

The polyol (component (O)) is a compound having two or more hydroxy groups (-OH). The component (O) is not particularly limited, and polyols commonly used in the production of urethane resins can be used without particular limitation.

The component (O) may be an aliphatic polyol or an aromatic polyol. Alternatively, the component (O) may be a low-molecular-weight polyol or a high-molecular-weight polyol.

In the present specification and claims, the term "aliphatic" is a relative concept used with respect to a term "aromatic", and defines a group with no aromaticity, a compound with no aromaticity, or the like. The term "alicyclic" refers to a non-aromatic group or a non-aromatic compound having a cyclic structure.

Specifically, as the low-molecular-weight polyol, dihydric alcohols such as ethylene glycol, 1,2-propylene glycol, 1,2-butanediol, 1,3-propylene glycol, 1,3-butanediol, 1,4-butanediol, 1,5-pentanediol, 1,6-hexane diol, neopentyl glycol, alkanediol having 7 to 22 carbon atoms, diethylene glycol, triethylene glycol, dipropylene glycol, 3-methyl-1,5-pentanediol, 2-ethyl-2-butyl-1,3-propanediol, alkan-1,2-diol having 17 to 20 carbon atoms, 1,3-cyclohexanedimethanol, 1,4-cyclohexanedimethanol, 1,4-cyclohexanediol, hydrogenated bisphenol A, 1,4-dihydroxy-2-butene, 2,6-dimethyl-1-octen-3,8-diol, and bisphenol A; trihydric alcohols such as glycerin and trimethylolpropane; tetrahydric alcohols such as tetramethylolmethane (pentaerythritol) and diglycerin; pentahydric alcohols such as xylitol; hexahydric alcohols such as sorbitol, mannitol, allitol, iditol, dulcitol, altritol, inositol, and dipentaerythritol; heptahydric alcohols such as perseitol; and octahydric alcohols such as sucrose are exemplary examples. Among these, a diol having a number-average molecular weight of 50 to 300 is preferable, and ethylene glycol, diethylene glycol, triethylene glycol, 1,2-propylene glycol, 1,3-propylene glycol, 1,3-butanediol, 1,4-butanediol, 1,5-pentanediol, 1,6-hexanediol, or neopentyl glycol is more preferable. These may be used alone, or two or more thereof may be used in combination.

Specifically, as the high-molecular-weight polyol, a phenol resin, a resin having a hydroxystyrene skeleton, polyester polyol, polyether polyol, polyetherester polyol, polyesteramide polyol, acrylic polyol, polycarbonate polyol, polyhydroxyalkane, polyurethane polyol, polycaprolactone polyol, vegetable oil polyol, and the like are exemplary examples. Among these, polycaprolactone polyol is preferable. These may be used alone, or two or more thereof may be used in combination. A number-average molecular weight of the high-molecular-weight polyol is preferably 300 to 2,000, more preferably 300 to 1,500, and still more preferably 300 to 900.

As the polyisocyanate compound (component (I)), an aliphatic diisocyanate, an alicyclic diisocyanate, an aromatic diisocyanate, or a mixture thereof can be used. As the aliphatic diisocyanate, hexamethylene diisocyanate is preferable.

As the above-described alicyclic diisocyanate, hydrogenated xylene diisocyanate, isophorone diisocyanate, 1,3-bisisocyanatomethylcyclohexane, 1,4-bisisocyanatomethylcyclohexane, norbornane diisocyanate, or dicyclohexylmethane-4,4'-diisocyanate is preferable.

As the above-described aromatic diisocyanate, 4,4-diphenylmethane diisocyanate is preferable.

Among these, the component (I) is preferably an aliphatic or alicyclic diisocyanate.

These may be used alone, or two or more thereof may be used in combination.

The hydroxyl group-containing (meth)acrylate has at least one hydroxyl group and one or more (meth)acryloyl groups in one molecule.

As the hydroxyl group-containing (meth)acrylate, for example, unsaturated fatty acid hydroxyalkyl esters such as 2-hydroxyethyl (meth)acrylate, 2-hydroxypropyl (meth)acrylate, and 4-hydroxybutyl (meth)acrylate; ε-caprolactone adducts of the unsaturated fatty acid hydroxyalkyl ester (average addition molar number: 1 to 10); polyethylene glycol (average addition molar number: 1 to 10) mono(meth)acrylate and polypropylene glycol (average addition molar number: 1 to 10) mono(meth)acrylate; pentaerythritol mono(meth)acrylate, pentaerythritol di(meth)acrylate, and pentaerythritol tri(meth)acrylate; dipentaerythritol di(meth)acrylate, dipentaerythritol tri(meth)acrylate, dipentaerythritol tetra(meth)acrylate, and dipentaerythritol penta(meth)acrylate; glycerin mono(meth)acrylate, diglycerin tri(meth)acrylate, and diglycerin di(meth)acrylate; sorbitol mono(meth)acrylate, sorbitol di(meth)acrylate, sorbitol tri(meth)acrylate, and sorbitol tetra(meth)acrylate; and the like are exemplary examples.

Among these, the hydroxyl group-containing (meth)acrylate is preferably an unsaturated fatty acid hydroxyalkyl ester.

One kind of the hydroxyl group-containing (meth)acrylate may be used alone, or two or more kinds thereof may be used in combination.

A weight-average molecular weight (Mw) of the thermosetting elastomer is preferably 2,000 or more and 30,000 or less, more preferably 2,000 or more and 20,000 or less, and still more preferably 3,000 or more and 10,000 or less.

In a case where Mw of the thermosetting elastomer is equal to or higher than the lower limit value of the above-described preferred range, strength in a case of being formed into a cured product is easily enhanced, and in a case of being equal to or lower than the upper limit value of the above-described preferred range, it is easy to achieve a low elastic modulus in a case of being formed into a cured product.

In the present specification and claims, the weight-average molecular weight (Mw) of the thermosetting elastomer means a value converted to standard polystyrene obtained by GPC measurement.

Among the above, it is preferable that the thermosetting elastomer is a urethane (meth)acrylate having a weight-average molecular weight of 2,000 or more and 30,000 or less, which is obtained by reacting polycaprolactone polyol having a number-average molecular weight of 300 or more and 900 or less, an aliphatic or alicyclic diisocyanate, and a hydroxyl group-containing (meth)acrylate.

### <<Polyfunctional (meth)acrylate compound>>

In addition, as the component (P), a polyfunctional (meth)acrylate compound may be used.

In the present specification, the "polyfunctional" means having two or more functional groups. For example, a polyfunctional monomer includes a monomer having two functional groups, a monomer having three functional groups, a monomer having four functional groups, and a monomer having more functional groups. A polyfunctional acrylate includes diacrylate, triacrylate, and tetraacrylate. In addition, a polyfunctional methacrylate includes dimethacrylate, trimethacrylate, and tetramethacrylate.

As the polyfunctional (meth)acrylate compound, for example, trifunctional monomers such as ethoxylated (3) trimethylolpropane triacrylate, ethoxylated (3) trimethylolpropane trimethacrylate, ethoxylated (6) trimethylolpropane triacrylate, ethoxylated (9) trimethylolpropane triacrylate, ethoxylated (15) trimethylolpropane triacrylate, ethoxylated (20) trimethylolpropane triacrylate, pentaerythritol triacrylate, pentaerythritol trimethacrylate, propoxylated (3) glyceryl triacrylate, propoxylated (3) glyceryl triacrylate, propoxylated (5.5) glyceryl triacrylate, propoxylated (3) trimethylolpropane triacrylate, propoxylated (6) trimethylolpropane triacrylate, trimethylolpropane triacrylate, trimethylolpropane trimethacrylate, tris-(2-hydroxyethyl)-isocyanurate triacrylate, tris-(2-hydroxyethyl)-isocyanurate trimethacrylate, EO-modified trimethylolpropane tri(meth)acrylate, PO-modified trimethylolpropane tri(meth)acrylate, and EO or PO-modified trimethylolpropane tri(meth)acrylate; tetrafunctional monomers such as ditrimethylolpropane tetraacrylate, ethoxylated (4) pentaerythritol tetraacrylate, and pentaerythritol tetra(meth)acrylate; and penta- or higher-functional monomers such as dipentaerythritol pentaacrylate and dipentaerythritol hexaacrylate are exemplary examples.

One kind of the component (P) may be used alone, or two or more kinds thereof may be used in combination.

### <Component (M): powdery magnetostrictive material>

The component (M) is a powdery material which is slightly deformed in a case where a magnetic field is applied.

An average particle size of a group of particles of the component (M) is preferably 5 µm or more and 50 µm or less, more preferably 5 µm or more and 40 µm or less, and still more preferably 5 µm or more and 30 µm or less.

In a case where the average particle size of the group of particles of the component (M) is equal to or higher than the lower limit value of the above-described preferred range, favorable dispersibility is easily obtained, and in a case of being equal to or lower than the upper limit value of the above-described preferred range, favorable surface smoothness is easily obtained.

In the present specification and claims, the average particle size of the group of particles of the component (M) indicates a volume-average particle size measured by a test method in accordance with a particle size analysis-laser diffraction/scattering method specified by JIS Z 8825: 2013.

As the component (M), a group of metal particles including Ni, Fe-Ni-based alloy, Fe-Co-based alloy, Fe-Al-based alloy, Fe-Ga-Al-based alloy, Fe-Dy-Tb-based alloy, or Fe-Ga-based alloy is an exemplary example.

Among these, the component (M) preferably consists of an iron-based magnetostrictive alloy. As the iron-based magnetostrictive alloy, it is preferable to use Fe-Co-based alloy, Fe-Ga-Al-based alloy, Fe-Dy-Tb-based alloy, or Fe-Ga-based alloy, and it is more preferable to use Fe-Co-based alloy.

Specifically, as the Fe-Co-based alloy, Fe_{(100 at% - x - y)}-Coₓ-V_{y} (where, x = 30 to 90 at% and y = 0 to 10 at%) is an exemplary example.

Specifically, as the Fe-Al-based alloy, Fe_{(100 at% - x)}-Alₓ (where, x = 40 to 80 at%) is an exemplary example.

Specifically, as the Fe-Ga-Al-based alloy, (Fe_{(100 at% - x - y})-Gaₓ-Al_{y})_{100 at% -z}-C_{z} (where, x = 10 to 15 at%, y = 4 to 7 at%, and z = 0 to 2 at%); and (Fe_{(100 at% - x - y)}-Gaₓ-Al_{y)100 at% - z}-B_{z} (where, x = 10 to 15 at%, y = 4 to 7 at%, and z = 0 to 2 at%) are exemplary examples.

The above-described specific examples of the Fe-Ga-Al-based alloy are an FeGaAl-based alloy including C (carbon) or B (boron).

As the Fe-Dy-Tb-based alloy, for example, Terfenol-D is an exemplary example.

As the Fe-Ga-based alloy, for example, Galfenol is an exemplary example.

One kind of the component (M) may be used alone, or two or more kinds thereof may be used in combination. Among the above, from the viewpoint of magnetostrictive properties and dispersion stability in the base material, the component (M) is preferably a group of particles consisting of an iron-based magnetostrictive alloy and having an average particle size of 5 µm or more and 50 µm or less.

### <Component (R): radical polymerization initiator>

The component (R) is a radical polymerization initiator, and in a case of curing the composition, the component (P) acts on the polymerizable group of the component (R) to promote the polymerization reaction and contributes to the formation of the base material (matrix) of the cured product. As the component (R), a thermal radical polymerization initiator, a photoradical polymerization initiator, and the like are exemplary examples.

### <<Thermal radical polymerization initiator>

As the thermal radical polymerization initiator, for example, peroxide and an azo-based polymerization initiator are exemplary examples.

As the peroxide in the thermal radical polymerization initiator, for example, ketone peroxides, peroxyketals, hydroperoxides, dialkyl peroxides, peroxyesters, and the like are exemplary examples.

Specifically, as such peroxides, acetyl peroxide, dicumyl peroxide, tert-butyl peroxide, t-butyl cumyl peroxide, propionyl peroxide, benzoyl peroxide (BPO), 2-chlorobenzoyl peroxide, 3-chlorobenzoyl peroxide, 4-chlorobenzoyl peroxide, 2,4-dichlorobenzoyl peroxide, 4-bromomethylbenzoyl peroxide, lauroyl peroxide, potassium persulfate, diisopropyl peroxycarbonate, tetralin hydroperoxide, 1-phenyl-2-methylpropyl-1-hydroperoxide, tert-butyl pertriphenylacetate, tert-butyl hydroperoxide, tert-butyl performate, tert-butyl peracetate, tert-butyl perbenzoate, tert-butyl perphenylacetate, tert-butyl per-4-methoxyacetate, tert-butyl per-N-(3-toluyl)carbamate, and the like are exemplary examples.

As the above-described peroxide, for example, commercially available products such as trade name "PERCUMYL (registered trademark)", trade name "PERBUTYL (registered trademark)", trade name "PEROYL (registered trademark)", and trade name "PEROCTA (registered trademark)", manufactured by NOF CORPORATION, can be used.

As the azo-based polymerization initiator in the thermal radical polymerization initiator, for example, 2,2'-azobispropane, 2,2'-dichloro-2,2'-azobispropane, 1,1'-azo(methylethyl)diacetate, 2,2'-azobis(2-amidinopropane) hydrochloride, 2,2'-azobis(2-aminopropane) nitrate, 2,2'-azobisisobutane, 2,2'-azobisisobutyramide, 2,2'-azobisisobutyronitrile, methyl 2,2'-azobis-2-methylpropionate, 2,2'-dichloro-2,2'-azobisbutane, 2,2'-azobis-2-methyl butyronitrile, 2,2'-azobis(2-methylpropionate)dimethyl(dimethyl 2,2'-azobisisobutyrate), 1,1'-azobis(1-methylbutyronitrile-3-sodium sulfonate), 2-(4-methylphenylazo)-2-methylmalonodinitrile, 4,4'-azobis-4-cyanovaleric acid, 3,5-dihydroxymethylphenylazo-2-allylmalonodinitrile, 2,2'-azobis-2-methylvaleronitrile, dimethyl 4,4'-azobis-4-cyanovalerate, 2,2'-azobis-2,4-dimethylvaleronitrile, 1,1'-azobiscyclohexanenitrile, 2,2'-azobis-2-propylbutyronitrile, 1,1'-azobiscyclohexanenitrile, 2,2'-azobis-2-propylbutyronitrile, 1,1'-azobis-1-chlorophenylethane, 1,1'-azobis-1-cyclohexanecarbonitrile, 1,1'-azobis-1-cycloheptanenitrile, 1,1'-azobis-1-phenylethane, 1,1'-azobiscumene, ethyl 4-nitrophenylazobenzylcyanoacetate, phenylazodiphenylmethane, phenylazotriphenylmethane, 4-nitrophenylazotriphenylmethane, 1,1'-azobis- 1,2-diphenylethane, poly(bisphenol A-4,4'-azobis-4-cyanopentanoate), poly(tetraethylene glycol-2,2'-azobisisobutyrate), and the like are exemplary examples.

### < <Photoradical polymerization initiator> >

As the photoradical polymerization initiator, for example, 1-hydroxycyclohexylphenyl ketone, 2-hydroxy-2-methyl-1-phenylpropan-1-one, 1-[4-(2-hydroxyethoxy)phenyl]-2-hydroxy-2-methyl-1-propan-1-one, 1-(4-isopropylphenyl)-2-hydroxy-2-methylpropan-1-one, 1-(4-dodecylphenyl)-2-hydroxy-2-methylpropan-1-one, 2,2-dimethoxy-1,2-diphenylethan-1-one, bis(4-dimethylaminophenyl)ketone, 2-methyl-1-[4-(methylthio)phenyl]-2-morpholinopropan-1-one, 2-benzyl-2-dimethylamino-1-(4-morpholinophenyl)-butan-1-one, ethanone 1-[9-ethyl-6-(2-methylbenzoyl)-9H-carbazol-3-yl]-1-(o-acetyloxime), 2,4,6-trimethylbenzoyldiphenylphosphine oxide, 4-benzoyl-4'-methyldimethylsulfide, 4-dimethylaminobenzoic acid, methyl 4-dimethylaminobenzoate, ethyl 4-dimethylaminobenzoate, 4-dimethylamino butyl benzoate, 4-dimethylamino-2-ethylhexylbenzoic acid, 4-dimethylamino-2-isoamylbenzoic acid, benzyl-β-methoxyethyl acetal, benzyl dimethyl ketal, 1-phenyl-1,2-propanedione-2-(o-ethoxycarbonyl) oxime, methyl o-benzoylbenzoate, 2,4-diethylthioxanthone, 2-chlorothioxanthone, 2,4-dimethylthioxanthone, 1-chloro-4-propoxythioxanthone, thioxanthene, 2-chlorothioxanthene, 2,4-diethylthioxanthene, 2-methylthioxanthene, 2-isopropylthioxanthene, 2-ethylanthraquinone, octamethylanthraquinone, 1,2-benzanthraquinone, 2,3-diphenylanthraquinone, azobisisobutyronitrile, benzoyl peroxide, cumene peroxide, 2-mercaptobenzimidazole, 2-mercaptobenzoxazole, 2-mercaptobenzothiazole, 2-(o-chlorophenyl)-4,5-diphenylimidazole dimer, 2-(o-chlorophenyl)-4,5-di(methoxyphenyl)imidazole dimer, 2-(o-fluorophenyl)-4,5-diphenylimidazole dimer, 2-(o-methoxyphenyl)- 4,5-diphenylimidazole dimer, 2-(p-methoxyphenyl)-4,5-diphenylimidazole dimer, 2,4,5-triarylimidazole dimer, benzophenone, 2-chlorobenzophenone, 4,4'-bisdimethylaminobenzophenone (that is, Michler's ketone), 4,4'-bisdiethylaminobenzophenone (that is, ethyl Michlers ketone), 4,4'-dichlorobenzophenone, 3,3-dimethyl-4-methoxybenzophenone, benzyl, benzoin, benzoin methyl ether, benzoin ethyl ether, benzoin isopropyl ether, benzoin-n-butyl ether, benzoin isobutyl ether, benzoin-t-butyl ether, acetophenone, 2,2-diethoxyacetophenone, p-dimethylacetophenone, p-dimethylaminopropiophenone, dichloroacetophenone, trichloroacetophenone, p-t-butylacetophenone, p-dimethylaminoacetophenone, p-t-butyltrichloroacetophenone, p-t-butyldichloroacetophenone, α,α-dichloro-4-phenoxyacetophenone, thioxanthone, 2-methylthioxanthone, 2-isopropyl thioxanthone, dibenzosuberone, pentyl-4-dimethylaminobenzoate, 9-phenylacridine, 1,7-bis-(9-acridinyl)heptane, 1,5-bis-(9-acridinyl)pentane, 1,3-bis-(9-acridinyl)propane, p-methoxytriazine, 2,4,6-tris(trichloromethyl)-s-triazine, 2-methyl-4,6-bis(trichloromethyl)-s-triazine, 2-[2-(5-methylfuran-2-yl)ethenyl]-4,6-bis(trichloromethyl)-s-triazine, 2-[2-(furan-2-yl)ethenyl]-4,6-bis(trichloromethyl)-s-triazine, 2-[2-(4-diethylamino-2-methylphenyl)ethenyl]-4,6-bis(trichloromethyl)-s-triazine, 2-[2-(3,4-dimethoxyphenyl)ethenyl]-4,6-bis(trichloromethyl)-s-triazine, 2-(4-methoxyphenyl)-4,6-bis(trichloromethyl)-s-triazine, 2-(4-ethoxystyryl)-4,6-bis(trichloromethyl)-s-triazine, 2-(4-n-butoxyphenyl)-4,6-bis(trichloromethyl)-s-triazine, 2,4-bis-trichloromethyl-6-(3-bromo-4-methoxy)phenyl-s-triazine, 2,4-bistrichloromethyl-6-(2-bromo-4-methoxy)phenyl-s-triazine, 2,4-bis-trichloromethyl-6-(3-bromo-4-methoxy)styrylphenyl-s -triazine, 2,4-bis-trichloromethyl-6-(2-bromo-4-methoxy)styrylphenyl-s-triazine, and the like are exemplary examples.

As the above-described photoradical polymerization initiator, for example, commercially available products such as "IRGACURE OXE02", "IRGACURE OXE01", "IRGACURE 369", "IRGACURE 651", and "IRGACURE 907" (all trade names, manufactured by BASF) and "NCI-831" (trade name, manufactured by ADEKA CORPORATION) can be used.

One kind of the component (R) may be used alone, or two or more kinds thereof may be used in combination. As the component (R), the thermal radical polymerization initiator is preferable, and among these, the azo-based polymerization initiator is more preferable.

The total content of the component (P), the component (M), and the component (R) in the composition according to the present embodiment is preferably 80% by volume or more, more preferably 90% by volume or more, still more preferably 95% by volume or more, and may be 100% by volume. It is particularly preferable to be 100% by volume, that is, it is preferable that the composition according to the present embodiment consists of the component (P), the component (M), and the component (R).

In the composition according to the present embodiment, the content of the component (M) is preferably 10% by volume or more and 80% by volume or less, and more preferably 20% by volume or more and 70% by volume or less with respect to the total volume (100% by volume) of the component (P), the component (M), and the component (R).

In a case where the content of the component (M) is within the above-described preferred range, the composition can exhibit both the positive magnetostriction and the negative magnetostriction.

In addition, in a case where the content of the component (M) is equal to or higher than the lower limit value of the above-described preferred range, the magnetostrictive properties are more likely to be exhibited, and in a case of being equal to or lower than the upper limit value of the above-described preferred range, the strength of the cured product is further enhanced.

In the composition according to the present embodiment, from the viewpoint that the composition tends to exhibit negative magnetostrictive properties, the content of the component (M) is preferably 40% by volume or more and 60% by volume or less, and more preferably 45% by volume or more and 55% by volume or less with respect to the total volume (100% by volume) of the component (P), the component (M), and the component (R).

In the composition according to the present embodiment, by controlling the volume fraction of the powdery magnetostrictive material in the cured product to a specific ratio as described above, although the details are not clear, it is considered that magnetostrictive material particles magnetized by the application of the magnetic field attract each other, so that the negative magnetostrictive properties are exhibited.

In addition, in the composition according to the present embodiment, the content of the component (R) is preferably 0.01 parts by mass or more and 20 parts by mass or less, more preferably 0.1 parts by mass or more and 15 parts by mass, and still more preferably 0.5 parts by mass or more and 10 parts by mass or less with respect to 100 parts by mass of the component (P).

In a case where the content of the component (R) is equal to or higher than the lower limit value of the above-described preferred range, an efficiency of the polymerization reaction between the components (P) is further improved, and in a case of being equal to or lower than the upper limit value of the above-described preferred range, the polymerization reaction is sufficiently promoted and the strength of the cured product is further enhanced.

### <Other components>

In addition to the component (P), the component (M), and the component (R), the composition according to the present embodiment may contain a component other than these components as necessary.

As the component other than the component (P), the component (M), and the component (R), for example, a solvent, a surfactant, a dispersant, an antifoaming agent, an antioxidant, a fragrance, a plasticizer, and the like are exemplary examples.

### [Method for preparing composition]

The composition according to the present embodiment can be prepared by a production method including a step of mixing the component (P), the component (M), the component (R), and other components as necessary with each other.

Alternatively, the composition according to the present embodiment can be prepared by a production method including a first step of mixing the component (P) and the component (R) with each other to obtain a mixture (PR) and a second step of mixing the mixture (PR) obtained in the first step with the component (M).

In the second step, a mixing ratio (volume ratio) of the mixture (PR) and the component (M) is preferably component (M)/mixture (PR) = 10/90 to 80/20, and more preferably component (M)/mixture (PR) = 20/80 to 70/30. By controlling the volume ratio of the mixture (PR) and the component (M) within the above-described preferred range, the composition can exhibit both the positive magnetostriction and the negative magnetostriction.

Furthermore, since the composition can exhibit negative magnetostriction, in the second step, the mixing ratio (volume ratio) of the mixture (PR) and the component (M) is preferably component (M)/mixture (PR) = 40/60 to 60/40, and more preferably component (M)/mixture (PR) = 45/55 to 55/45.

### (Cured product)

The cured product according to the present embodiment is obtained by curing the (composition having magnetostrictive properties) described above. A shape of the cured product is not particularly limited, and for example, a plate shape, a cylindrical shape, and a prismatic shape are exemplary examples.

### [Method for manufacturing cured product]

For example, the cured product according to the present embodiment can be manufactured by a manufacturing method including a step of pouring the above-described composition into a mold of a predetermined shape and performing heat-curing treatment.

The heat-curing treatment may be performed in one operation, or may be performed in two or more operations.

As described above, the composition according to the present embodiment is a magnetostrictive composite material having magnetostrictive properties, which contains the component (P): the compound having a polymerizable group, the component (M): the powdery magnetostrictive material, and the component (R): the radical polymerization initiator. That is, the composition according to the present embodiment is a novel magnetostrictive composite material in which the powdery magnetostrictive material is employed and the magnetostrictive material is dispersed in the base material which is cured by a radical polymerization. Therefore, the composition according to the present embodiment is different from the magnetostrictive composite material in the related art, in which a wire consisting of an iron-based magnetostrictive alloy is embedded in a base material (matrix) as a filler material (filler), in that there is no complexity and simple handling is possible.

In addition, in the composition according to the present embodiment, since the polymerizable compound constituting the base material can be selected, it is possible to provide a magnetostrictive composite material in which the magnetostrictive material is composited with various polymers.

As such a magnetostrictive composite material, for example, it is possible to provide a magnetostrictive composite material which can withstand repeated stress loading by compositing the magnetostrictive material with a low elastic modulus polymer.

Alternatively, the composition according to the present embodiment can also be applied to applications such as composite material substrates. For example, by laminating and curing a fiber-reinforced plastic such as a glass fiber-reinforced plastic and a carbon fiber-reinforced plastic and a sheet including the composition according to the present embodiment or a cured product thereof, it is possible to provide an FRP bulk having a magnetostrictive effect.

Furthermore, in the composition according to the present embodiment, by controlling the mixing ratio of the polymerizable compound constituting the base material and the powdery magnetostrictive material, it is also possible to provide a magnetostrictive composite material which exhibits not only positive magnetostriction (elongation in the direction of applied magnetic field) but also negative magnetostriction (contraction in the direction of applied magnetic field).

According to the composition of the embodiment, compared with a single magnetostrictive material, it can be expected to further improve energy harvesting and stress sensor functions in a case where bending stress or bending vibration is used.

The composition according to the embodiment is useful as a smart material because it is a kind of material which causes some kind of reaction to an external stimulus.

### [Examples]

Hereinafter, the present invention will be described in more detail with reference to examples, but the present invention is not limited to these examples.

### <Preparation of composition>

Component (P), component (M), and component (R) shown below were used in a case of preparing a composition of each example.

· Component (P): compound having a polymerizable group
Compound (P-1): urethane acrylate (product name: DA-800AU, NOF CORPORATION) was used as a thermosetting elastomer resin; glass transition temperature of cured product: -30°C

The compound (P-1) was obtained by reacting polycaprolactone diol having a number-average molecular weight of 530 with isophorone diisocyanate and 2-hydroxyethyl acrylate. A weight-average molecular weight of the compound (P-1) was 5200.

Compound (P-2): dipentaerythritol hexaacrylate (product name: KAYARAD DPHA, Nippon Kayaku Co., Ltd.) was used as a thermosetting resin; glass transition temperature of cured product: higher than 250°C
· Component (M): powdery magnetostrictive material

Fe₄₉Co₄₉V₂ (Epson Atmix Corporation) was used. An average particle size was 8.0 ± 1.0 µm.

· Component (R): radical polymerization initiator
2,2'-azobis(2-methylpropionate)dimethyl was used as a thermal radical polymerization initiator.

### (Example 1)

3 parts by mass of the component (R) was added to 100 parts by mass of the compound (P-1) and dissolved by stirring to obtain a uniform solution.

Next, the component (M) was added thereto so as to have a volume fraction shown in Table 1, and the mixture was stirred to prepare a composition which was a dispersion liquid in which the powdery magnetostrictive material was dispersed.

The volume fraction was calculated assuming that the density of Fe₄₉Co₄₉V₂ as the component (M) was 8.6 g/cm³ and the density of the compound (P-1) and the component (R) was 1.0 g/cm³.

### (Examples 2 to 4)

In the same manner as in Example 1, a composition was prepared as the dispersion liquid in which the powdery magnetostrictive material was dispersed, except that the volume fraction was changed as shown in Table 1.

### (Example 5)

3 parts by mass of the component (R) was added to 100 parts by mass of the compound (P-2) and dissolved by stirring to obtain a uniform solution.

Next, the component (M) was added thereto so as to have a volume fraction shown in Table 2, and the mixture was stirred to prepare a composition which was a dispersion liquid in which the powdery magnetostrictive material was dispersed.

The volume fraction was calculated assuming that the density of Fe₄₉Co₄₉V₂ as the component (M) was 8.6 g/cm³ and the density of the compound (P-2) and the component (R) was 1.0 g/cm³.

### (Examples 6 to 8)

In the same manner as in Example 5, a composition was prepared as the dispersion liquid in which the powdery magnetostrictive material was dispersed, except that the volume fraction was changed as shown in Table 2.

### <Manufacturing of cured product sample>

The composition of each example was poured into a 10 mm × 10 mm × 2 mm mold.

Thereafter, each mold was placed on a ceramic hot plate (CHP-170DF (ASONE)) and heat-cured at 80°C for 2 hours under nitrogen flow. Thereafter, a heat-curing treatment at 120°C was further performed for 1 hour to obtain a cured product sample.

### <Evaluation of magnetostrictive properties>

FIG. 1 is a schematic diagram representing a method for evaluating magnetostrictive properties in the present example.

In FIG. 1, a cured product sample 20 was placed between a pair of electromagnets 10 and 10.

An orthogonal strain gauge 30 was attached to a 6 mm square area on a surface of the cured product sample 20, and a magnetic field from -1 tesla to 1 tesla was applied to the surface of the cured product sample 20 horizontally and in one direction (z-axis direction) by the electromagnets 10. The direction horizontal to the surface of the cured product sample 20 and orthogonal to the z-axis direction was defined as an x-axis direction.

A deformation state of the cured product sample 20 at this time was evaluated using a vibrating sample magnetometer. The evaluation results are each shown in Tables 1 and 2 and FIGS. 2 to 4.

**[Table 1]**

| | | Example 1 | Example 2 | Example 3 | Example 4 |
|---|---|---|---|---|---|
| Compound (P-1) | Mass ratio | 100 | 100 | 100 | 100 |
| Component (R) | | 3 | 3 | 3 | 3 |
| Total of compound (P-1) and component (R) | Volume ratio | 79 | 68 | 49 | 31 |
| Component (M) | | 21 | 32 | 51 | 69 |
| Positive or negative magnetostriction | | Positive | Positive | Negative | Positive |

**[Table 2]**

| | | Example 5 | Example 6 | Example 7 | Example 8 |
|---|---|---|---|---|---|
| Compound (P-2) | Mass ratio | 100 | 100 | 100 | 100 |
| Component (R) | | 3 | 3 | 3 | 3 |
| Total of compound (P-2) and component (R) | Volume ratio | 79 | 68 | 49 | 31 |
| Component (M) | | 21 | 32 | 51 | 69 |
| Positive or negative magnetostriction | | Positive | Positive | Positive | Positive |

From the results in Table 1, with regard to the cured products obtained by curing the compositions of Examples 1 to 4, in which the compound (P-1) was used as the component (P), it was confirmed that the cured products obtained by curing the compositions of Examples 1, 2, and 4 exhibited "positive magnetostriction" and only the cured product obtained by curing the composition of Example 3 exhibited "negative magneto striction".

From the results in Table 2, with regard to the cured products obtained by curing the compositions of Examples 5 to 8, in which the compound (P-2) was used as the component (P), it was confirmed that all exhibited "positive magnetostriction".

FIG. 2 is a schematic plan view of component (M) particles dispersed in a cured product sample before and after application of a magnetic field.

In FIG. 2, an arrow (z-axis direction) indicates an application direction of the magnetic field.

FIG. 2(A) shows a state of component (M) particles 20a dispersed in the cured product sample before the application of the magnetic field, and the component (M) particles 20a have a substantially circular shape in plan view.

FIG. 2(B) shows a state of the component (M) particles dispersed in the cured product sample after the application of the magnetic field. Compared to the state of component (M) particles 21b before the magnetic field was applied, after applying the magnetic field, component (M) particles 22b were elongated in the direction of application of the magnetic field, and had a substantially elliptical shape in plan view with a major axis parallel to the z-axis. That is, a composition in which such component (M) particles were dispersed had positive magnetostrictive properties.

FIG. 2(C) shows a state of the component (M) particles dispersed in the cured product sample after the application of the magnetic field. Compared to the state of component (M) particles 23c before the magnetic field was applied, after applying the magnetic field, component (M) particles 24c contracted in the direction of application of the magnetic field, and had a substantially elliptical shape in plan view with a major axis orthogonal to the z-axis. That is, a composition in which such component (M) particles were dispersed had negative magnetostrictive properties.

FIG. 3 is a diagram representing the change in shape of the component (M) particles dispersed in the cured product sample upon the application of the magnetic field, with regard to a cured product obtained by curing the composition of Example 6. The vertical axis indicates magnetostriction, λ (ppm). The horizontal axis indicates magnetic flux density, B (mT).

With regard to the composition of Example 6, positive magnetostrictive properties were confirmed in which, with the application of the magnetic field, the cured product sample expanded in the z-axis direction which was the direction of applied magnetic field, and contracted in the x-axis direction which was a direction orthogonal to the direction of applied magnetic field.

FIG. 4 is a diagram representing the change in shape of the component (M) particles dispersed in the cured product sample upon the application of the magnetic field, with regard to a cured product obtained by curing the composition of Example 3. The vertical axis indicates magnetostriction, λ (ppm). The horizontal axis indicates magnetic flux density, B (mT).

With regard to the composition of Example 3, negative magnetostrictive properties were confirmed in which, with the application of the magnetic field, the cured product sample contracted in the z-axis direction which was the direction of applied magnetic field, and exhibited slight expansion and contraction in the x-axis direction which was a direction orthogonal to the direction of applied magnetic field.

Although preferred examples of the present invention are described above, the present invention is not limited to these examples. It is possible to add other configurations or to omit, replace, or modify the configurations described herein without departing from the spirit of the present invention. The present invention is not limited by the above description, but only by the scope of the appended claims.

### [Reference Signs List]

10: Electromagnet
20: Cured product sample
30: Strain gauge

## Claims

1. A composition having magnetostrictive properties, comprising:
a component (P): a compound having a polymerizable group;
a component (M): a powdery magnetostrictive material; and
a component (R): a radical polymerization initiator.

2. The composition according to Claim 1,
wherein the component (M) is a group of particles consisting of an iron-based magnetostrictive alloy and having an average particle size of 5 µm or more and 50 µm or less.

3. The composition according to Claim 1 or 2,
wherein a content of the component (M) is 40% by volume or more and 60% by volume or less with respect to a total volume of the component (P), the component (M), and the component (R), and
the composition has negative magnetostrictive properties.

4. The composition according to any one of Claims 1 to 3,
wherein a content of the component (R) is 0.01 parts by mass or more and 20 parts by mass or less with respect to 100 parts by mass of the component (P).

5. The composition according to any one of Claims 1 to 4,
wherein the component (P) is a thermosetting resin having a polymerizable unsaturated double bond.

6. The composition according to any one of Claims 1 to 5,
wherein the component (P) is a thermosetting elastomer having a glass transition temperature of -130°C or higher and -5°C or lower.

7. The composition according to Claim 6,
wherein the thermosetting elastomer is a urethane (meth)acrylate.

8. The composition according to Claim 7,
wherein the thermosetting elastomer is a urethane (meth)acrylate having a weight-average molecular weight of 2,000 or more and 30,000 or less, which is obtained by reacting polycaprolactone polyol having a number-average molecular weight of 300 or more and 900 or less, an aliphatic or alicyclic diisocyanate, and a hydroxyl group-containing (meth)acrylate.

9. A cured product obtained by curing the composition according to any one of Claims 1 to 8.
